# EUROPEAN PATENT APPLICATION

(11) **EP 2 672 618 A1**
(43) Date of publication of application: **11.12.2013**
(21) Application number: 12170647.7
(22) Date of filing: 04.06.2012
(51) Int. Cl.: H02M 7/00, H05K 7/20

(54) **Modular motor inverter arrangement with cooling sections forming inner duct ring capacitor on the outside**

(71) Applicant: ABB Oy, 00380 Helsinki (FI)
(72) Inventor: Seväkivi, Pertti, 00380 Helsinki (FI); Heikkilä, Teemu, 00380 Helsinki (FI)
(74) Representative: Kolster Oy Ab

(57) **Abstract**

The invention relates to an arrangement for a modular inverter. The arrangement comprises a number of power semiconductors (5, 7) and cooling elements (2), the cooling elements being connected to the power semiconductors (5, 7) for cooling them, wherein the power semiconductors (5, 7) and the cooling elements (2) are disposed around a centre axis (9) of the arrangement in such a manner that they demark a channel (10) around the centre axis (9) in which a cooling medium is able to flow in the direction of the centre axis. The invention is characterized in that the arrangement further comprises a first tube-shaped ring film capacitor (11) around the centre axis (9) of the arrangement wherein the power semiconductors (5, 7) are arranged between the cooling elements (2) and an inner surface of the first ring film capacitor (11).

## Description

### FIELD OF THE INVENTION

The invention relates to a modular inverter arrangement.

### BACKGROUND OF THE INVENTION

An inverter is an electrical device enabling generation of a voltage with a variable frequency. Typically, inverters are used in connection with motors for controlling them with a variable frequency or, correspondingly, when electrical power is transmitted back to the network, whereby the inverter must generate a voltage with a frequency that corresponds to the frequency of the network. Such an inverter feeding the network is generally called a network inverter. An inverter may also be a part of a frequency converter used for controlling a motor or another load. A frequency converter is typically formed of two converters, i.e. a rectifier and an inverter, between which there is a direct-voltage or direct-current intermediate circuit. The rectifier and the inverter may also be positioned physically separated from each other and one rectifier may feed several inverters via a common intermediate circuit or, alternatively, several rectifiers may feed one inverter. An example of a rectifier is a diode bridge or a thyristor bridge. Frequency converters also typically include one or more choke devices. Examples of such choke devices used in or in connection with frequency converters include an input choke connected to the input of the rectifier of the frequency converter, and an output choke connected to the output of the inverter of the frequency converter.

Frequency converter structures presently in use typically include an input choke, an input bridge, a capacitor bank and an IGBT (Insulated-Gate Bipolar Transistor) module. The capacitor bank is usually a complicated set of multiple capacitors and it usually requires cooling. Up to protection class IP20 (Ingress Protection), mechanical devices are usually constructed with one blower, in which the main flow of cooling medium, such as air, is conveyed to the cooling element of the power semiconductors and to other objects by means of the kind of distribution they require. The cooling element is, as a rule, a one-part or a multi-part element, the parts being bunched together with support mechanics.

In protection class IP21 or in higher protection classes, the electronics space (what is called clean room) and the space for the cooling element (what is called dirty room) are typically separated from each other for practical reasons. In order for both spaces to have the right amount of air, both spaces are generally provided with a blower of its own. The possible input choke is often positioned on the dirty side, either in a separate air space or in the space following the cooling element. Alternatively, the possible AC input choke may also be replaced by a DC choke connected to the intermediate circuit but in this case, too, the mechanical position of the choke is in the same place. The possible structure-specific output choke is often positioned mechanically in the same place as the input choke. In some structures, the possible chokes are positioned completely outside the device, in which case they are, due to the cooling and their own support mechanism, larger in size than they would be if integrated.

Present inverter and frequency converter structures or, more generally, motor controller structures are problematic particularly with regard to arranging the cooling. Although the size of the cooling element or elements required has continuously been on the decrease owing to more accurate designing, smaller losses and physically smaller power semiconductors, the required amount of air (or amount of another cooling medium) relative to the outer dimensions of the device has even increased. Also, distribution of a sufficient amount of air is preferably done by means of a large blower at a low blasting rate, taking into account the power, sound and service life of the blower. For this reason, the space required by the cooling is, relative to the size of the device, rather large in solutions presently in use. This is further emphasized in IP21 or higher protection classes, in particular.

### BRIEF DESCRIPTION OF THE INVENTION

An object of the invention is to provide an apparatus in such a way that the above problem can be solved or at least alleviated. The object of the invention is achieved with an arrangement and a modular inverter which are characterized by what is stated in the independent claims. Preferred embodiments of the invention are disclosed in the dependent claims.

The invention is based on the idea that power semiconductors and cooling elements associated with them are disposed around a centre axis of the arrangement inside at least one tube-shaped ring film capacitor in such a manner that the cooling elements demark a channel around the centre axis from at least three sides, to which channel cooling surfaces of the cooling elements extend and in which a cooling medium is able to flow in the direction of the centre axis.

An advantage of the solution is that the structure according to the invention provides a natural channel for the flow of the cooling medium, which enables controlled circulation of the cooling medium, such as air, through the device because a tube shaped capacitor surrounds the power stages and the cooling elements. Owing to this, the cooling can be implemented efficiently while saving space at the same time. Further, the invention allows the cooling to be implemented uniformly in different parts of the device. Furthermore, the solution according to the invention enables a modular structure, which provides advantages for the production and maintenance of the device, for example.

### BRIEF DESCRIPTION OF THE FIGURES

The invention will now be described in greater detail in connection with preferred embodiments, referring to the attached drawings, of which:

Figure 1 shows the arrangement according to an embodiment of an inverter unit, seen from above;

Figure 2 shows the arrangement according to an embodiment of a combination of an inverter unit and an inverter supply unit, seen from above;

Figure 3 shows the arrangement according to an embodiment of a three-level inverter unit, seen from above;

### DETAILED DESCRIPTION OF THE INVENTION

The invention can be applied in connection with various inverter solutions and is thus not restricted to be used in connection with any particular type of device. As an example, an inverter unit, a combination of an inverter unit and an inverter supply unit, and a three-level inverter unit are presented here as embodiments of the invention. However, the invention should not be considered to be restricted to these three devices or a combination of them, as any person skilled in the art should understand. The types of the inverter feed, the load controlled by the inverter or the connections between them, such as the voltage level or the number of phases, is not relevant to the basic idea of the invention either. Further, the internal or external electrical connections of the inverter in connection with which the invention is applied are not relevant to the invention, so the electrical connections are, for the sake of clarity, omitted from the figures. The invention is not confined to the examples shown in the figures but may be applied to other types of inverter solutions as well.

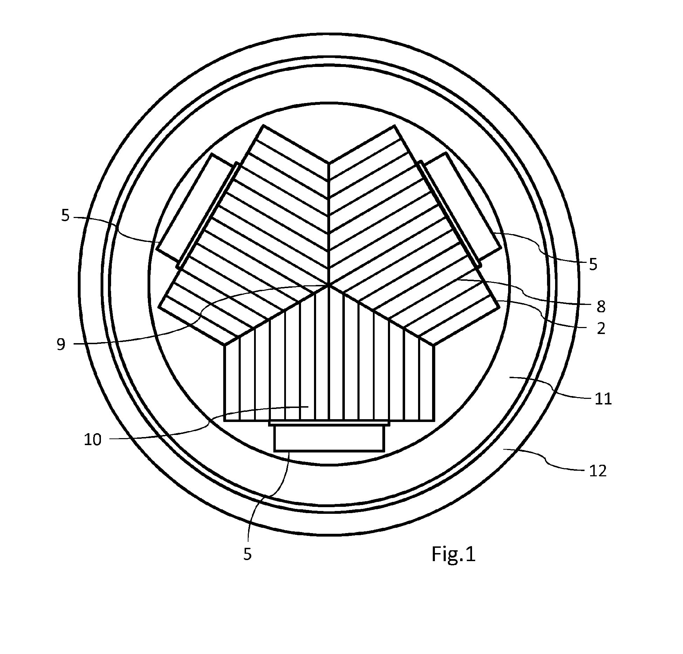

Figure 1 shows a top view of the arrangement according to an embodiment. The arrangement shown in Figure 1 comprises three power semiconductors 5, or three groups of power semiconductors, and three cooling elements 2 connected to the power semiconductors, one for each power semiconductor 5. The power semiconductors form three identical power stages U, V, W. In accordance with the embodiment, the power semiconductors 5 as well as the cooling elements 2 are disposed around a centre axis 9 of the arrangement in such a manner that cooling surfaces 8 of the cooling elements extend from the connections between the power semiconductors 5 and the cooling elements 2 substantially towards the centre axis 9, and the power semiconductors 5 extend from the connections between the power semiconductors and the cooling elements substantially away from the centre axis 9 in such a manner that a channel 10 is demarked around the centre axis from at least three sides, in which channel the cooling surfaces 8 of the cooling elements are located and in which the cooling medium is able to flow in the direction of the centre axis 9. The cooling medium may be for example dirty air or liquid. The power semiconductors and related printed circuit boards are in a clean room between the inner surface of a first ring film capacitor 11 and the cooling elements 2.

In the arrangement of the example in Figure 1, the channel 10 is demarked around the centre axis 9. The cooling elements 2 and the power semiconductors 5 are fitted inside a tube-shaped ring film capacitor 11 having a circular cross-section. The ring film capacitor 11 does not necessarily have to be round, in the direction of the centre axis 9, and for example a tube having a cross-section of a round-edged triangle or a square could also be used. The ring film capacitor comprises a roll of conducting and isolating material. The ring film capacitor has a certain capacitance which depends on, for example, the number of turns in the roll, isolator's thickness and height of the roll. Current and voltage handling capacity can be enhanced by using a thicker conductor and isolator, respectively.

Preferably two capacitors are used and a second ring film capacitor 12 has the same shape as the first ring film capacitor 11 but different physical size so that the first ring film capacitor 11 is fits inside the second ring film capacitor 12. Therefore the first ring film capacitor 11 has a smaller diameter and it preferably has more turns than the second ring film capacitor 12 to match the capacitance of the second ring film capacitor. The capacitors are connected in series by connecting one terminal of each of the capacitors together. This connection also generates a neutral point therein. In an embodiment the capacitor comprises a cooling element, for example a cooling fin or a set of cooling fins, which may be fixed to the neutral point.

The series-connected ring film capacitors 11, 12 function as a DC capacitor of the inverter arrangement. A separate clamp capacitor may be omitted from the inverter arrangement because the DC capacitor is so close to the power semiconductors 5. The construction of the arrangement also offers many other benefits. A high capacitance can be achieved with a simple arrangement of the two ring capacitors. The capacitors do not block the channel 10 which is used for cooling the power semiconductors 5, and cooling of the capacitors can still be easily realized. The channel may also be easily modified for water cooling purposes. A system with very low inductance can be arranged with the inverter arrangement by using ring film capacitors having a short length. The inverter arrangement is also easily scalable for higher power levels by making the capacitors longer, thicker, and/or increasing the number of turns in the capacitor.

The power semiconductors 5, or groups of power semiconductors, are preferably installed to the inverter arrangement in a modular fashion, so that they can be removed and replaced one by one in case of a breakdown. Preferably each power semiconductor 5 is fixed to a separate cooling element 2, so that in case of a breakdown the broken power semiconductor can be removed with its cooling element while the other power semiconductors and cooling elements remain in their place. The pairs of power semiconductors 5 and cooling elements 2 may be installed, for example, with a help of guides and slots or on rails, or they may be fastened to the inverter device but preferably not to each other.

The inverter arrangement may comprise at least one choke. The at least one choke may be mounted on a top or a bottom surface of the cooling elements. Said at least one choke may be an air-core choke. Further, said at least one choke may be an input choke and/or an output choke.

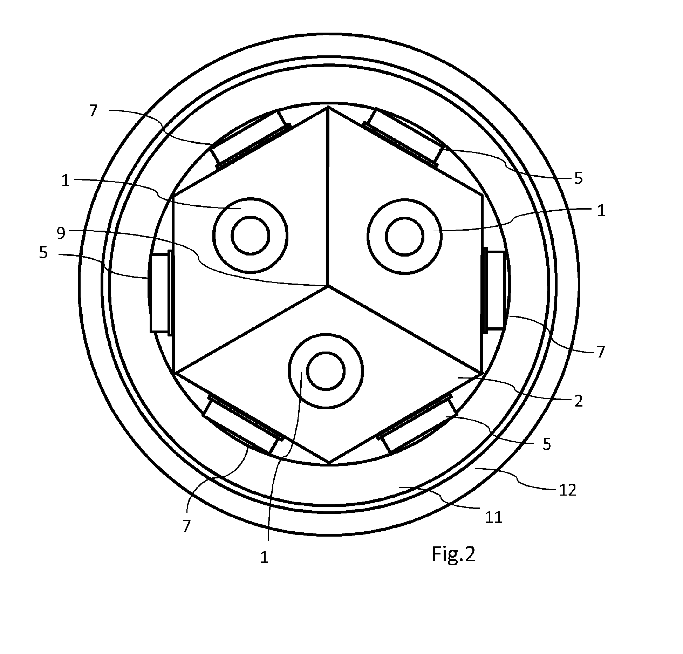

The arrangement of the exemplary embodiment in Figure 2 comprises six power semiconductors 5, 7, or six power semiconductor groups and three cooling elements 2. The cooling elements 2 comprise plate-like or fin-like cooling surfaces similar to the cooling surfaces 8 of Figure 1 even though the cooling surfaces are not illustrated in Figure 2. The cooling elements 2 demark a channel 10 in which a cooling medium is able to flow in the direction of the centre axis 9. The cooling medium may be for example dirty air or liquid. The power semiconductors and related printed circuit boards are in a clean room between an inner surface of a first ring film capacitor 11 and the cooling elements 2.

The arrangement of Figure 2 can be used as an inverter unit with a first set of power semiconductors 5 and as an inverter supply unit with a second set of power semiconductors 7. The inverter arrangement may comprise at least one choke 1. The at least one choke 1 may be mounted on a top or a bottom surface of the cooling elements. Said at least one choke may be an air-core choke. Further, said at least one choke 1 may be an input choke and/or an output choke. Aluminium or copper cooling elements 2, for example, do not react much to the magnetic flux of the choke 1. Thus, the support structures and outer casings (not shown) of the cooling elements 2 are as far from the choke 1 as possible, so that the magnetic flux caused by the choke 1 cannot disturb external devices or the inverter's own electronics. In addition, possible heating in the support structures, caused by the magnetic flux, is taken care of by the cooling medium flow directly or indirectly via the cooling elements 2.

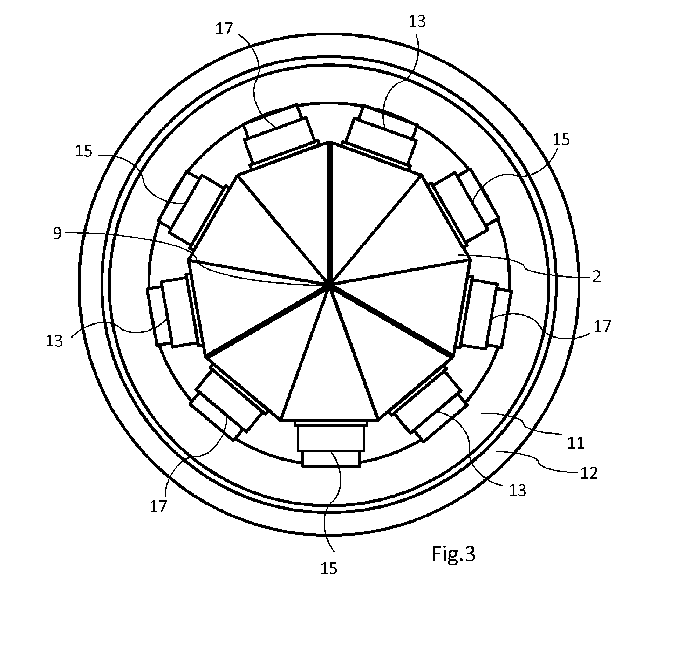

Figure 3 shows a top view of the arrangement according to an embodiment of a three-level inverter. The arrangement of the exemplary embodiment in Figure 3 comprises nine power semiconductors 13, 15, 17, or nine groups of power semiconductors 13, 15, 17, and nine cooling elements 2. The power semiconductors form three identical power stages U, V, W. Preferably, the middle power semiconductor 15 of each power stage is upside down compared to the other power semiconductors 13, 17, thus enabling short output wiring. The cooling elements 2 comprise plate-like or fin-like cooling surfaces similar to the cooling surfaces 8 of Figure 1 even though the cooling surfaces are not illustrated in Figure 2. The cooling elements 2 demark a channel 10 in which a cooling medium is able to flow in the direction of the centre axis 9. The cooling medium may be for example dirty air or liquid. The power semiconductors and related printed circuit boards are in a clean room between an inner surface of a first ring film capacitor 11 and the cooling elements 2. The inverter arrangement may comprise at least one choke. The at least one choke may be mounted on a top or a bottom surface of the cooling elements. Said at least one choke may be an air-core choke. Further, said at least one choke may be an input choke and/or an output choke.

It is further to be noted that, for the sake of clarity, many parts possibly present in the device utilizing the invention have been omitted from the figures associated with the above examples. The mechanical attachment of the structure is shown in a much reduced manner in the figures. For the sake of simplicity, the mechanical and electrical connections of the semiconductor modules 5, 7, 13, 15, 17 to each other and the electrical connections of the modules to, for example, chokes 1 and user interfaces (not shown), implementable in several alternative ways, have been omitted from the figures.

Within the embodiments described above or in addition to them, the structure according to the invention may be used in a plurality of additional embodiments. The structure according to the invention may be utilized for implementing the basic structure of an inverter, rectifier or frequency converter.

When utilized in connection with various electrical components, the mechanical structure according to the invention typically works optimally in a lot wider area than present structures. Owing to this, the structure according to the invention enables implementation of modularity through the whole device/series of devices, such as a frequency converter, involving not only one device but also its internal structures (e.g. power unit, choke unit, blower unit, control unit). Modularity in this sense may be considered to refer to standardizing the attachment points of each internal unit. The overall advantages obtained in this way for the manufacture may be significant.

It will be obvious to a person skilled in the art that as the technology advances, the basic idea of the invention may be implemented in a plurality of ways. The invention and its embodiments are thus not restricted to the examples described above but may vary within the scope of the claims.

## Claims

1. An arrangement for a modular inverter, the arrangement comprising a number of power semiconductors (5, 7) and cooling elements (2), the cooling elements being connected to the power semiconductors (5, 7) for cooling them, wherein the power semiconductors (5, 7) and the cooling elements (2) are disposed around a centre axis (9) of the arrangement in such a manner that they demark a channel (10) around the centre axis (9) from at least three sides, to which channel cooling surfaces (8) of the cooling elements extend and in which a cooling medium is able to flow in the direction of the centre axis, and the power semiconductors (5, 7) extend from the connections between the power semiconductors and the cooling elements substantially away from the centre axis, **characterized in that** the arrangement further comprises a first tube-shaped ring film capacitor (11) around the centre axis (9) of the arrangement, wherein the power semiconductors (5, 7) are arranged between the cooling elements (2) and the inner surface of the first ring film capacitor (11).

2. An arrangement according to claim 1, **characterized in that** the power semiconductors (5, 7) are divided into three or more groups, whereby there is at least one cooling element (2) associated with each group.

3. An arrangement according to claim 1 or 2, **characterized in that** the arrangement further comprises at least one choke (1) disposed in the channel (10) demarked around the centre axis (9).

4. An arrangement according to claim 3, **characterized in that** said at least one choke (1) is an air-core choke.

5. An arrangement according to claim 3 or 4, **characterized in that** said at least one choke (1) is an input choke and/or an output choke.

6. An arrangement according to any one of claims 1 to 5, **characterized in that** each of the power semiconductors (5, 7) is in connection with a single cooling element (2) and is arranged to be removed and replaced together without removing any other cooling elements (2).

7. An arrangement according to any one of claims 1 to 6, **characterized in that** the arrangement comprises a blower for blowing dirty air into the channel (10) in order to cool down the cooling elements (2) and the power semiconductors (5, 7, 9).

8. An arrangement according to any one of claims 1 to 7, **characterized in that** the arrangement further comprises a second tube-shaped ring film capacitor (12) around the first ring film capacitor (11).

9. An arrangement according to claim 8, **characterized in that** a terminal of the first ring film capacitor (11) is connected to a terminal of the second ring film capacitor (12) in such a manner that the connection generates a neutral point at the connected terminals.

10. A motor controller, comprising an arrangement according to any one of claims 1 to 9.

11. A motor controller according to claim 10, **characterized in that** the motor controller is an inverter, a rectifier or a frequency converter.
